Europäisches Patentamt

European Patent Office

Office européen des brevets

(19)

(11) Publication number: **0 095 826**
B1

(12) **EUROPEAN PATENT SPECIFICATION**

(45) Date of publication of patent specification: **01.06.88**

(51) Int. Cl.⁴: **H 01 S 3/19**, H 01 S 3/05

(21) Application number: **83301600.9**

(22) Date of filing: **22.03.83**

(54) Semiconductor laser.

(30) Priority: **28.05.82 JP 91636/82**
**23.06.82 JP 108706/82**
**21.02.83 JP 28075/83**

(43) Date of publication of application:
**07.12.83 Bulletin 83/49**

(45) Publication of the grant of the patent:
**01.06.88 Bulletin 88/22**

(84) Designated Contracting States:
**DE GB NL**

(56) References cited:
**US-A-4 282 494**
**IEEE JOURNAL OF QUANTUM ELECTRONICS,**
**vol. 17, no. 10, October 1981, NEW YORK (US).**
**MASAYASU UENO: "Optimum design for**
**AlGaAs window stripe lasers", pages 2113-**
**2122**
**IEEE JOURNAL OF QUANTUM ELECTRONICS,**
**vol. 15, no. 8, August 1979, NEW YORK (US).**
**H.O. YONEZU et al.: "An AlGaAs window**
**structure laser", pages 775-781**
**APPLIED PHYSICS LETTERS, vol. 34, no. 10, 15**
**May 1979, NEW YORK (US). H. YONEZU et al.:**
**"High Optical power density emission from a**
**window-stripe AlGaAs double-hetero-**
**structure laser", pages 637-639**

(73) Proprietor: **SHARP KABUSHIKI KAISHA**
**22-22 Nagaike-cho Abeno-ku**
**Osaka 545 (JP)**

(72) Inventor: **Yamamoto, Saburo**
**1-2-11 Akanedai Haibara-cho**
**Uda-gun Nara-ken (JP)**
Inventor: **Hayashi, Hiroshi**
**11-5-8 Nakamodai Kamo-cho**
**Soraku-gun Kyoto-fu (JP)**
Inventor: **Yano, Seiki**
**126-80 Toyoto-cho**
**Kashihara-shi Nara-ken (JP)**

(74) Representative: **Wright, Peter David John et al**
**R.G.C. Jenkins & Co. 26 Caxton Street**
**London SW1H 0RJ (GB)**

(56) References cited:

**APPLIED PHYSICS LETTERS, vol. 40, No. 12, 15**
**June 1982, NEW YORK (US). H. BLAUVELT et**
**al.: "Large optical cavity AlGaAs buried**
**heterostructure window lasers", pages 1029-**
**1031**

Courier Press, Leamington Spa, England.

## Description

### BACKGROUND AND SUMMARY OF THE INVENTION

The present invention relates to a semiconductor laser and, more particularly, to a laser device construction which ensures stable operation.

A semiconductor laser enjoys a limited period of life depending on deterioration at mirrors which function as the light emitting facet. Furthermore, a semiconductor laser may be damaged at mirrors if the semiconductor laser is driven in a considerably high optical power. The maximum optical power for catastrophical optical damage (referred to as $P_{max}$ hereinafter) is about $10^6$ W/cm² in the conventional semiconductor laser.

It is a great desire to increase the $P_{max}$ to achieve a stable high power oscillation. Furthermore, the absorption of the high density laser beam near the mirrors must be restricted as low as possible in order to minimize the mirror deterioration.

To achieve the above desires, a window structure laser has been proposed in, for example, Appl. Phys. Lett. 15 May, 1979 P. 637. Another structure has also been proposed wherein a material is doped near the mirror, the material having the wider band-gap energy than that of the active layer. From US—A—4282 494 there is known a window structure semiconductor laser comprising a stimulated region including an active layer and window regions formed at both ends of said stimulated region, each of said window regions including a plane active layer which functions as a waveguide.

Generally, the conventional window structure semiconductor laser does not have the optical waveguide formed in the window region along the junction. Thus, the laser beam diffuses in the window region so as to reduce the beam amount directed to the stimulated region after the reflection at the mirror. This will reduce the oscillation efficiency, and will increase the threshold current.

Accordingly, an object of the present invention is to increase the oscillation efficiency in a window structure semiconductor laser.

Another object of the present invention is to provide a semiconductor laser which stably emits the laser beam in the visible spectral range.

Other objects and further advantages of the present invention will become apparent from the detailed description given hereinafter. It should be understood, however, that the detailed description and specific examples, while indicating preferred embodiments of the invention, are given by way of illustration only.

To achieve the above objects, pursuant to the present invention, a window structure semiconductor laser is formed comprising: a stimulated region including a crescent portion of an active layer; and window regions formed at both ends of said stimulated region, each of said window regions including a plane portion of said active layer which functions as a waveguide. The crescent portion of the active layer and the plane portion of the active layer are formed in the stimulated region and the window region, respectively, under the same manufacturing condition, for instance by a liquid phase epitaxy method. An embodiment of the invention having a V-shaped groove in a current blocking layer is named the window V-channeled substrate inner stripe (referred to as VSIS hereinafter) laser.

The thus formed window region functions to suppress the higher transverse mode generated in the stimulated region so that only the fundamental transverse mode is transferred in the window region and developed through the mirror. The window VSIS laser according to an embodiment of the present invention has low threshold current because the current is perfectly confined in the V channel by the inner stripe.

### BRIEF DESCRIPTION OF THE DRAWINGS

The embodiments of the present invention will be better understood from the detailed description given hereinbelow and the accompanying drawings which are given by way of illustration only, and thus are not limitative of the present invention and wherein:

FIGURE 1 is a schematic plan view showing wave fronts in the conventional window structure semiconductor laser;

FIGURE 2 is a schematic plan view showing wave fronts in an embodiment of a window structure semiconductor laser of the present invention;

FIGURE 3 is a sectional view of the window structure semiconductor laser of FIGURE 2 taken along lines III—III of FIGURE 2;

FIGURE 4 is a sectional view of the window structure semiconductor laser of FIGURE 2 taken along line IV—IV of FIGURE 2;

FIGURE 5 is a schematic plan view showing a step of manufacturing the window structure semiconductor laser of FIGURE 2;

FIGURE 6 is a schematic sectional view of an essential part of the window structure semiconductor laser of FIGURE 2 taken along line VI—VI of FIGURE 5;

FIGURE 7 is a schematic sectional view of an essential part of the window structure semiconductor laser of FIGURE 2 taken along line VII—VII of FIGURE 5;

FIGURE 8 is a schematic plan view showing another step of manufacturing the window structure semiconductor laser of FIGURE 2;

FIGURE 9 is a schematic plan view showing wave fronts in another embodiment of a window structure semiconductor laser of the present invention;

FIGURE 10 is a sectional view of the window structure semiconductor laser of FIGURE 9 taken along line X—X of FIGURE 9;

FIGURE 11 is a sectional view of the window structure semiconductor laser of FIGURE 9 taken along line XI—XI of FIGURE 9;

FIGURE 12 is a schematic plan view showing a step of manufacturing the window structure semiconductor laser of FIGURE 9;

FIGURE 13 is a schematic plan view shwoing another step of manufacturing the window structure semiconductor laser of FIGURE 9;

FIGURE 14 is a schematic sectional view of an essential part of the window structure semiconductor laser of FIGURE 9 taken along line XIV—XIV of FIGURE 13;

FIGURE 15 is a schematic sectional view of an essential part of the window structure semiconductor laser of FIGURE 9 taken along line XV—XV of FIGURE 13;

FIGURE 16 is a schematic plan view showing still another step of manufacturing the window structure semiconductor laser of FIGURE 9;

FIGURE 17 is a schematic plan view showing wave fronts in still another embodiment of a window structure semiconductor laser of the present invention;

FIGURE 18 is a sectional view of the window structure semiconductor laser of FIGURE 17 taken along line XVIII—XVIII of FIGURE 17;

FIGURE 19 is a sectional view of the window structure semiconductor laser of FIGURE 17 taken along line XIX—XIX of FIGURE 17;

FIGURE 20 is a schematic plan view showing a step of manufacturing the window structure semiconductor laser of FIGURE 17;

FIGURE 21 is a schematic sectional view of an essential part of the window structure semiconductor laser of FIGURE 17 taken along line XXI—XXI of FIGURE 20;

FIGURE 22 is a schematic sectional view of an essential part of the window structure semiconductor laser of FIGURE 17 taken along line XXII—XXII of FIGURE 20; and

FIGURE 23 is a schematic plan view showing another step of manufacturing the window structure semiconductor laser of FIGURE 17.

## DESCRIPTION OF THE PREFERRED EMBODIMENTS

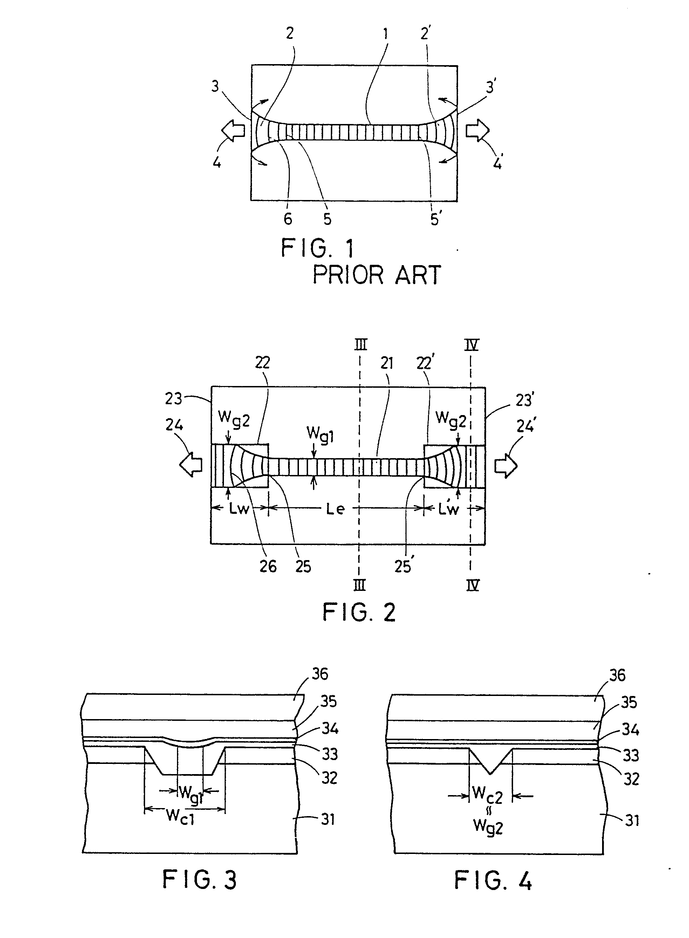

In order to facilitate a better understanding of the invention, the conventional window structure semiconductor laser will be first described with reference to FIGURE 1.

The window structure semiconductor laser generally includes a stripe shaped stimulated region 1, and a pair of window regions 2 and 2' formed at the both ends of the stimulated region 1. Laser beams 4 and 4' are emitted through mirrors 3 and 3' which are positioned at the end of the window regions 2 and 2', respectively. The ends 5 and 5' of the stimulated region 1 are placed between the mirrors 3 and 3'. Wave fronts 6 represent the transmission of the laser beam in the window regions 2 and 2'.

In the above-mentioned conventional window structure semiconductor laser, the beam waist for the field confined along the junction exists at the ends 5 and 5' of the stimulated region 1. The beam waist for the field perpendicular to the junction, however, exists at the mirrors 3 and 3'. The thus created astigmatism provides problems when the laser is coupled with an optical system.

FIGURE 2 shows an embodiment of a window structure semiconductor laser of the present invention.

The window structure semiconductor laser of FIGURE 2 includes a stimulated region 21, and a pair of window regions 22 and 22' formed at the both ends of the stimulated region 21. The stimulated region 21 has a length $L_e$ and a waveguide width $W_{g1}$. The window regions 22 and 22' have the waveguide width $W_{g2}$ and the length $L_w$ and $L_w'$, respectively. Laser beams 24 and 24' are emitted through mirrors 23 and 23' which are located at the ends of the window regions 22 and 22', respectively. The length $L_e$ of the stimulated region 21 is determined by the ends 25 and 25' which are positioned at the both ends of the stimulated region 21. Wave fronts 26 depict the laser beam transmission in the window regions 22 and 22'.

FIGURE 3 shows the construction of the stimulated region 21, and FIGURE 4 shows the construction of the window regions 22 and 22'.

The window structure semiconductor laser of FIGURE 2 includes a p-GaAs substrate 31, and an n-GaAs current blocking layer 32 formed on the p-GaAs substrate 31.

A V-shaped groove is formed in the current blocking layer 32 and the substrate 31. A p-GaAlAs cladding layer 33, a GaAs or GaAlAs active layer 34, an n-GaAlAs cladding layer 35, and an n-GaAs cap layer 36 are formed on the current blocking layer 32 as shown in FIGURES 3 and 4.

As shown in FIGURE 3, the stimulated region has the same construction as a VSIS laser with a crescent active layer, and the window region has, as shown in FIGURE 4, the same construction as a VSIS laser with a plane active layer. Such VSIS lasers are described in, for example, Transaction of Institute of Electronics and Communication Engineers of Japan, The Technical Group of Electron Devices (ED—81—42, 1981, P. 31). That is, the VSIS laser is an inner stripe laser, wherein a groove is formed in a substrate so that light and current is confined in a current path.

More specifically, the current for laser oscillation is blocked by the n-GaAs current blocking layer 32, whereby the current flows only in the channel portion of the width $W_{c1}$ and $W_{c2}$. The channel is constructed to have the width which fulfills the relation $W_{c1} > W_{c2}$. When the active layer 34 is formed on the thus formed channel portions, the crescent portion of the active layer is formed at the channel portion of the width $W_{c1}$, and the plane portion of the active layer is formed at the channel portion of the width $W_{c2}$ under the same manufacturing condition. The crescent portion of the active layer functions to form an index guide of which width $W_{g1}$ is narrower than the channel width $W_{c1}$. The plane portion of the active layer functions to form a waveguide based on the reduction of the effective refractive index due to the light absorption by the n-GaAs current blocking layer 32 at the edges of the channel portion. The thus formed waveguide has the width $W_{g2}$ which is substantially identical with the channel width $W_{c2}$.

When the VSIS laser with a crescent active layer and the VSIS laser with a plane active layer are formed under the same condition, the VSIS laser with the crescent active layer generates the laser beam of the wavelength which is 10 through 20 mm (100 through 200 Å) longer than that of the laser beam generated by the VSIS laser with the plane active layer. That is, the VSIS laser with a crescent active layer has a narrower band-gap energy than the VSIS with a plane active layer by 21 through 42 meV. The VSIS laser with a crescent active layer has a low threshold current as compared with the VSIS laser with a plane active layer. However, the transverse mode is not stable in the VSIS laser with a crescent active layer. The VSIS laser with a plane active layer ensures a stable transverse mode although the threshold current is high as compared with the VSIS laser with a crescent active layer. Accordingly, if the waveguide having the above-mentioned two active layer portions is formed at the same time under the same condition, the laser oscillation occurs at the crescent portion and the plane active layer portion functions to transmit the laser beam. The present invention is based on the above-mentioned facts. In accordance with the present invention, the plane portion of the active layer is formed at the both ends of the laser device having the crescent portion of the active layer, whereby the threshold current is reduced and the transverse mode is stabilized. The $P_{max}$ is increased and the mirror deterioration is minimized.

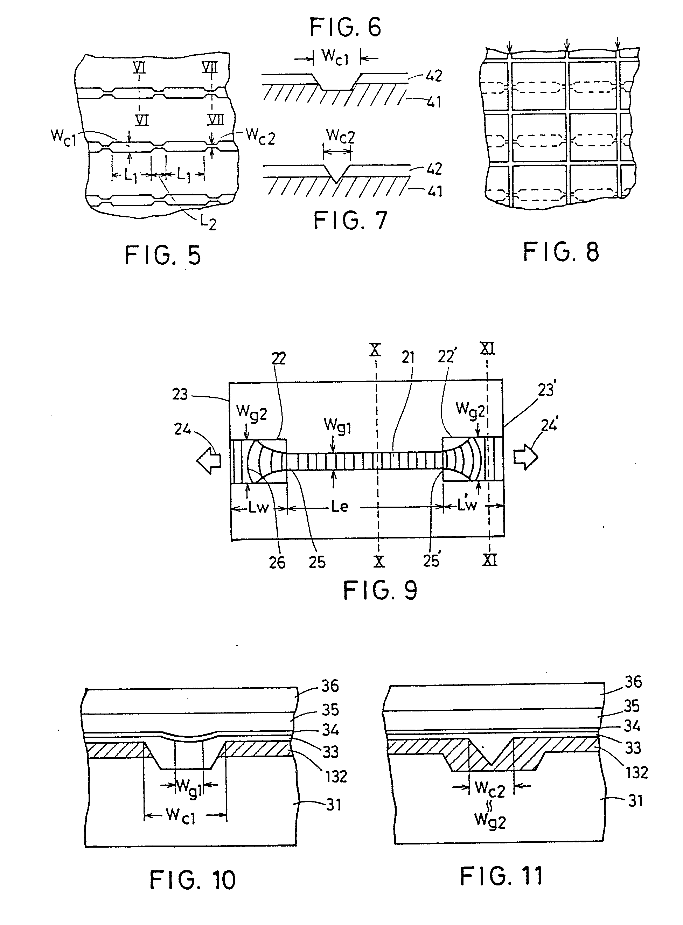

A method for manufacturing the window structure semiconductor laser of FIGURE 2 will be described with reference to FIGURES 5 through 8.

First, Te-doped n-GaAs layer 42 ($n = 6 \times 10^{18}$ cm$^{-3}$) of 0.6 μm thickness is grown on a Zn-doped p-GaAs substrate 41 ($p = 1 \times 10^{19}$ cm$^{-3}$) through the use of a liquid phase epitaxial method. Then, a stripe shaped pattern is formed on the n-GaAs layer 42 as shown in FIGURE 5 through the use of photolithography technique. The pattern has alternatingly repeating wider windows of 150 μm length ($L_1$) and 6 μm width ($W_{c1}$), and narrower windows of 100 μm length ($L_2$) and 3 μm width ($W_{c2}$). Through the windows the GaAs layer 42 is etched through the use of a sulfuric acid system etchant. FIGURE 6 shows an etched condition at the section VI—VI of FIGURE 5, which corresponds to the stimulated region. FIGURE 7 shows an etched condition of the section VII—VII of FIGURE 5, which corresponds to the window region.

Thereafter, the p-Ga$_{0.5}$Al$_{0.5}$As cladding layer 33, the p-Ga$_{0.85}$Al$_{0.15}$As active layer 34, the n-Ga$_{0.5}$Al$_{0.5}$As cladding layer 35, and the n-GaAs cap layer 36 are sequentially formed on the GaAs current blocking layer 32 (42) through the use of a liquid phase epitaxial method. The layers 33, 34, 35 and 36 have the thickness of 0.15 μm, 0.1 μm, 1.0 μm, and 2 μm, respectively, at the flat sections thereof. The active layer 34 has the thickness of 0.2 μm at the centre of the crescent portion.

The rear surface of the substrate 31 is lapped so that the wafer thickness becomes 100 μm. Electrode layers are formed by evaporating Au—Ge—Ni on the n-GaAs cap layer 36 and Au—Zn on the lapped rear surface of the p-GaAs substrate 31, respectively. The thus formed electrode layers are alloyed at 450°C. Thereafter, Al is evaporated on the rear surface of the p-GaAs substrate 31, and the Al is patterned in accordance with the inner channels as shown in FIGURE 8. The thus formed crystal is cleaved at the center of the window region, which has the length $L_2$, to obtain the total cavity length of 250 μm with the window regions of 50 μm length at the both ends thereof.

The above constructed window structure semiconductor laser of FIGURE 2 exhibits the laser oscillation of the wavelength 780 nm (7800 Å) at $I_{th} = 30$ mA. The $P_{max}$ is about 100 mW, and the stable fundamental transverse mode is obtained to 100 mW.

If the crystal is cleaved at the center of the stimulated region, the laser oscillation is conducted at the higher transverse mode, and the $P_{max}$ is about 10 mW. That is, in accordance with the present invention, the $P_{max}$ is increased to ten times.

In a preferred form, the mirror is coated by Al$_2$O$_3$.

In this case, the $P_{max}$ is increased to 200 mW.

When the window structure semiconductor laser according to the present invention is manufactured with the wavelength 830 nm (8300 Å), the $P_{max}$ is 200 mW when the mirror coat is not provided, and the $P_{max}$ is 400 mW if the mirror coat is provided.

Both of the window structure semiconductor lasers of the present invention with the wavelengths 780 nm and 830 nm (7800 Å and 8300 Å) enjoy stable continuous operation over 2500 hours under the output power 30 mW at 50°C.

In the window structure semiconductor laser of FIGURE 2, there is a possibility that the window regions 22 and 22′ satisfy the laser oscillation condition when the optical power is about 20 mW because the same current flows through the window regions 22 and 22′ as the stimulated region 21. This will preclude the generation of the stable transverse mode.

FIGURE 9 shows another embodiment of a window structure semiconductor laser of the present invention, wherein the current blocking layer in the window region is thicker than that in the stimulated region. Like elements corresponding to those of FIGURE 2 are indicated by like numerals.

FIGURE 10 shows the construction of the stimulated region 21, and FIGURE 11 shows the construction of the window regions 22 and 22′ of the window structure semiconductor laser of FIGURE 9. Like elements corresponding to those of FIGURES 3 and 4 are indicated by like numerals.

As shown in FIGURE 11, a current blocking layer 132 exists even at the center of the channel of the window regions 22 and 22′. Accordingly, the laser oscillation does not occur in the window regions 22 and 22', and the window regions operate only as the windows for transferring the laser beam generated from the stimulated region 21. In the embodiment of FIGURE 9, the laser oscillation with the stable transverse mode is observed up to the optical power of about 100 mV.

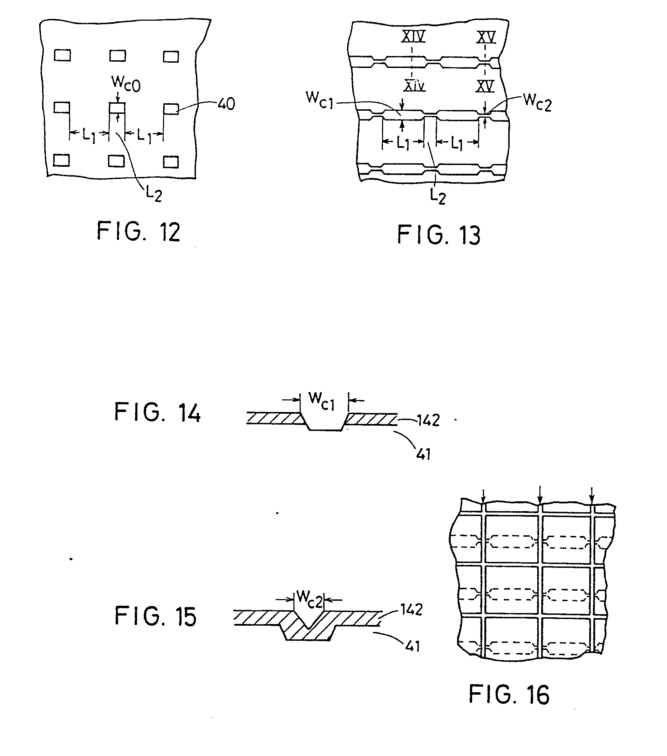

A method for fabricating the window structure semiconductor laser of FIGURE 9 will be described with reference to FIGURES 12 through 16, wherein like elements corresponding to those of FIGURES 5 through 8 are indicated by like numerals.

First, a mask pattern having periodical rectangular windows 40 shown in FIGURE 12 is formed on the Zn-doped p-GaAs substrate 41 (p = $1 \times 10^{19}$ cm$^{-3}$) through the use of a photolithography method. The rectangular windows 40 have the width ($W_{co}$) of 10 µm, and the length ($L_2$) of 100 µm. Each rectangular window is separated from the adjacent rectangular windows in a same line by the distance ($L_1$) of 150 µm. Through the thus formed rectangular windows 40, the GaAs substrate 41 is etched by a sulfuric acid system etchant to form rectangular grooves in the GaAs substrate 41 to the depth of 1 µm.

A Te-doped n-GaAs layer 142 (n = $6 \times 10^{18}$ cm$^{-3}$) of 0.8 µm thickness is grown on the GaAs substrate 41 through the use of the liquid phase epitaxial method. The rectangular grooves formed in the GaAs substrate 41 are filled by the n-GaAs layer 142. That is, the n-GaAs layer 142 has the thickness of 1.8 µm at the rectangular groove portions.

Then, the stripe shaped pattern is formed on the n-GaAs layer 142 as shown in FIGURE 13 in a same manner as the pattern of FIGURE 5. The narrower window sections correspond to the rectangular groove portions. Through the windows, the GaAs layer 142 is etched by a sulfuric acid system etchant. FIGURE 14 shows an etched condition at the section XIV—XIV of FIGURE 13, which corresponds to the stimulated region, and FIGURE 15 shows an etched condition at the section XV—XV of FIGURE 13, which corresponds to the window region. It will be clear from FIGURE 15, at the window regions 22 and 22', the V-shaped etched portion is completely covered by the n-GaAs current blocking layer 142 (132).

The remaining layers 33, 34, 35 and 36, and the electrode layers are formed in a same manner as described with reference to FIGURES 3 through 8.

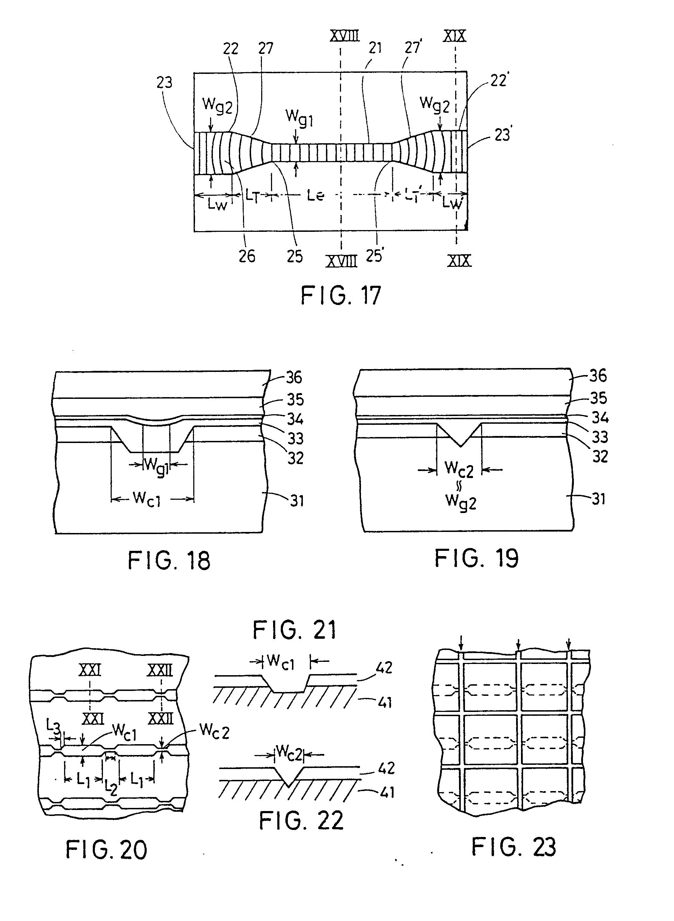

FIGURE 17 shows still another embodiment of a window structure semiconductor laser of the present invention. Like elements corresponding to those of FIGURE 2 are indicated by like numerals.

Tapered coupling regions 27 and 27' are disposed between the window region 22 and the stimulated region 21, and between the window region 22' and the stimulated region 21, respectively. The tapered regions 27 and 27' have the length $L_T$ and $L_T'$, respectively, and the waveguide width thereof linearly increases to properly couple the waveguide in the stimulated region 21 (width $W_{g1}$) with the waveguide in the window regions 22 and 22' (width $W_{g2}$). The construction of the stimulated region 21 is shown in FIGURE 18 which is identical with the construction shown in FIGURE 3. The construction of the window regions 22 and 22' is shown in FIGURE 19 which is identical with the construction shown in FIGURE 4.

FIGURE 20 shows a mask pattern formed on the n-GaAs layer 42. The pattern has alternatingly repeating wider windows of 150 µm length ($L_1$) and 6 µm width ($W_{c1}$), narrower windows of 100 µm length ($L_2$) and 3 µm width ($W_{c2}$), and tapered portions which has the length of 20 µm ($L_3$).

The remaining steps for manufacturing the window structure semiconductor laser of FIGURE 17 are similar to those discussed with reference to FIGURES 3 through 8. FIGURE 21 shows an etched condition at the wider windows, and FIGURE 22 shows an etched condition at the narrower windows. FIGURE 23 corresponds to FIGURE 8. Detailed description related to FIGURES 21 through 23 is omitted for the purpose of simplicity.

The tapered coupling regions 27 and 27' prevent the reduction of the differential efficiency, and ensure the stable transverse mode even when the ambient temperature varies.

The present invention is applicable not only to the window structure semiconductor laser of the GaAlAs type but also to the various window structure semiconductor lasers of the heterojunction type such as the InP-InGaAsP type.

## Claims

1. A window structure semiconductor laser comprising:
a stimulated region (21) including a crescent portion of an active layer (34); and
window regions (22, 22') formed at both ends of said stimulated region, each of said window regions including a plane portion of said active layer which functions as a waveguide, said crescent and said plane portion of the active layer being formed under the same manufacturing conditions.

2. A window structure semiconductor laser of claim 1, wherein:
said stimulated region defines a waveguide width (Wg1) which is narrower than a waveguide with (Wg2) determined by each of said window regions.

3. The window structure semiconductor laser of claim 2, further comprising:
a pair of tapered coupling regions (27, 27') formed between said stimulated region (21) and each of said window regions (22, 22'), each of said pair of tapered coupling regions defining a waveguide width linearly increasing from the waveguide width (Wg1) defined by said stimulated region to the waveguide width (Wg2) defined by each of said window regions.

4. A window structure semiconductor laser according to claim 1, comprising: a substrate (31);

a current blocking layer (32, 132) formed on said substrate;

a V-shaped groove formed in said current blocking layer, said V-shaped groove has a wider section (Wc1) within said stimulated region, and narrower sections (Wc2) within said window regions;

a cladding layer (33) formed on said current blocking layer;

an active layer (34) formed on said cladding layer, said active layer having its crescent portion formed at a position corresponding to said wider section of said V-shaped groove formed in said current blocking layer, and its plane portions formed at positions corresponding to said narrower sections of said V-shaped groove formed in said current blocking layer; and

another cladding layer (35) formed on said active layer.

5. The window structure semiconductor laser of claim 4, wherein said current blocking layer (132) has thicker sections formed at the positions corresponding to said narrower sections of said V-shaped groove, whereby said cladding layer (33) formed between said current blocking layer and said active layer (34) is separated from said substrate (31) by said current blocking layer at said narrower sections (Wc2) of said V-shaped groove.

6. The window structure semiconductor laser of claim 4, wherein:

said substrate comprises a p-GaAs substrate;

said current blocking layer comprises an n-GaAs layer;

said cladding layer comprises a p-GaAlAs layer; and

said active layer comprises a GaAs layer.

7. The window structure semiconductor laser of claim 4, wherein:

said substrate comprises a p-GaAs substrate;

said current blocking layer comprises an n-GaAs layer;

said cladding layer comprises a p-GaAlAs layer; and

said active layer comprises a GaAlAs layer.

8. The window structure semiconductor laser of claim 4, wherein:

said wider section of the V-shaped groove has a length of 150 μm; and

each of said narrower sections of said V-shaped groove has a length of 50 μm.

## Patentansprüche

1. Halbleiterlaser mit Fensterstruktur gekennzeichnet durch:

einen angeregten Bereich (21) mit einem sichelförmigen Teil aus einer aktiven Schicht (34), und

Fensterregionen (22, 22'), die an beiden Enden des angeregten Bereiches ausgebildet sind und jeweils einen ebenen Bereich der aktiven Schicht einschließen, der als Wellenleiter dient, wobei der sichelförmige und der ebene Abschnitt der aktiven Schicht unter denselben Herstellungsbedingungen hergestellt worden sind.

2. Halbleiterlaser nach Anspruch 1, dadurch gekennzeichnet, daß der angeregte Bereich eine Wellenleiterbreite (Wg1) abgrenzt, die schmaler ist als eine Wellenleiterbreite (Wg2), die von den Fensterbereichen bestimmt wird.

3. Halbleiterlaser nach Anspruch 2, weiterhin gekennzeichnet durch:

ein Paar konisch verlaufender Verbindungsbereiche (27, 27'), die jeweils zwischen den angeregten Bereichen (21) und jedem Fensterbereich (22, 22') gebildet sind und jeweils eine Wellenleiterbreite abgrenzen, die sich linear von der durch den angeregten Bereich festgelegten Wellenleiterbreite (Wg1) zu dem von dem jeweiligen Fensterbereich festgelegten Wellenleiterbreite (Wg2) vergrößert.

4. Halbleiterlaser nach Anspruch 1, gekennzeichnet durch:

ein Substrat (31);

eine auf dem Substrat liegende Strom-Sperrschicht (32, 132);

eine in der Strom-Sperrschicht ausgebildete V-förmige Rinne, deren breiterer Bereich (Wc1) innerhalb des angeregten Bereiches und deren schmalerer Bereich (Wc2) innerhalb des Fensterbereiches liegt;

eine auf der Strom-Sperrschicht ausgebildete Überzugsschicht (33);

eine auf der Überzugsschicht ausgebildete aktive Schicht (34), die einen sichelförmigen Abschnitt in einem dem breiteren Teil der in der Strom-Sperrschicht ausgebildeten V-förmigen Rinne gegenüberliegenden Bereich aufweist und deren ebene Abschnitt ein den den schmaleren Bereichen der in der Strom-Sperrschicht ausgebildeten V-förmigen Rinne gegenüberliegenden Bereichen liegen, und

eine weitere, auf der aktiven Schicht ausgebildete Überzugsschicht (35).

5. Halbleiterlaser nach Anspruch 4, dadurch gekennzeichnet, daß die Strom-Sperrschicht (132) dickere Bereiche an den den schmaleren Bereichen der V-förmigen Einkerbung gegenüberliegenden Stellen aufweist, und die zwischen der Strom-Sperrschicht und der aktiven Schicht (34) gebildete Überzugsschicht (33) durch die Strom-Sperrschicht von dem Substrat (31) an den schmaleren Bereichen (Wc2) der V-förmigen Einkerbung getrennt ist.

6. Halbleiterlaser nach Anspruch 4, dadurch gekennzeichnet, daß das Substrat ein p-GaAs-Substrat aufweist; die Strom-Sperrschicht eine n-GaAs-Schicht aufweist; die Überzugsschicht eine p-GaAlAs-Schicht aufweist und die aktive Schicht eine GaAs-Schicht aufweist.

7. Halbleiterlaser nach Anspruch 4, dadurch gekennzeichnet, daß das Substrat ein p-GaAs-Substrat aufweist; die Strom-Sperrschicht eine n-GaAs-Schicht aufweist; die Überzugsschicht eine p-GaAlAs-Schicht enthält; und die aktive Schicht eine GaAlAs-Schicht aufweist.

8. Halbleiterlaser nach Anspruch 4, dadurch gekennzeichnet, daß der breitere Bereich der V-förmigen Einkerbung eine Länge von 150 µm aufweist; und jeder der schmaleren Bereiche der V-förmigen Einkerbung eine Länge von 50 µm hat.

## Revendications

1. Laser à semi-conducteur doté d'une structure à fenêtres et comprenant:

une zone stimulée (21) incluant une partie en forme de croissant d'une couche active (34); et

des zones à fenêtre (22, 22') formées aux deux extrémités de ladite zone stimulée, chacune de ces zones à fenêtre incluant une partie plane de ladite couche active, qui remplit la fonction d'un guide d'ondes, ladite partie en forme de croissant et ladite partie plane de la couche active étant produites dans les mêmes conditions de fabrication.

2. Laser à semi-conducteur doté d'une structure à fenêtres, selon la revendication 1, dans lequel ladite zone stimulée définit une largeur de guide d'ondes (Wg1) plus étroite que la largeur de guide d'ondes (Wg2) déterminée par chacune desdites zones à fenêtre.

3. Laser à semi-conducteur doté d'une structure à fenêtres, selon la revendication 2, comprenant en outre deux zones de couplage effilées (27, 27') formées entre ladite zone stimulée (21) et chacune desdites zones à fenêtre (22, 22'), chacune de ces deux zones de couplage effilées définissant une largeur de guide d'ondes qui croît linéairement depuis la valeur de la largeur de guide d'ondes (Wg1) définie par ladite zone stimulée jusqu'à la valeur de la largeur de guide d'ondes (Wg2) définie par chacune desdites zones à fenêtre.

4. Laser à semi-conducteur doté d'une structure à fenêtres, selon la revendication 1, comprenant:

un substrat (31);

une couche d'arrêt de courant (32, 132) formée sur ce substrat;

une gorge en forme de V ménagée dans cette couche d'arrêt de courant, ladite gorge en forme de V yant une section élargie (Wc1) à l'intérieur de ladite zone stimulée, et des sections plus étroites (Wc2) à l'intérieur desdites zones à fenêtre;

une couche de placage (33) formée sur ladite couche d'arrêt de courant;

une couche active (34) formée sur cette couche de placage, ladite couche active ayant sa partie en forme de croissant formée en un emplacement correspondant à ladite section élargie de la gorge en forme de V ménagée dans la couche d'arrêt de courant, et ses parties planes formées en des emplacements correspondant auxdites sections plus étroites de la gorge en forme de V ménagée dans la couche d'arrêt de courant; et

une seconde couche de placage (35) formée sur ladite couche active.

5. Laser à semi-conducteur doté d'une structure à fenêtres, selon la revendication 4, dans lequel ladite couche d'arrêt de courant (132) présent des sections épaissies formées en des emplacements correspondant auxdites sections plus étroites de la gorge en forme de V, la couche de placage (33) qui est formée entre ladite couche d'arrêt de courant et ladite couche active (34) étant ainsi séparée dudit substrat (31) par la couche d'arrêt de courant, au droit desdites sections plus étroites (Wc2) de la gorge en forme de V.

6. Laser à semi-conducteur doté d'une structure à fenêtres, selon la revendication 4, dans lequel:

ledit substrat comprend un substrat en Ga As de type p;

ladite couche d'arrêt de courant comprend une couche en Ga As de type n;

ladite couche de placage comprend une couche en Ga Al As de type p; et

ladite couche active comprend une couche en Ga As.

7. Laser à semi-conducteur doté d'une structure à fenêtres, selon la revendication 4, dans lequel:

ledit substrat comprend un substrat en Ga As de type p;

ladite couche d'arrêt de courant comprend une couche en Ga As de type n;

ladite couche de placage comprend une couche en Ga Al As de type p; et

ladite couche active comprend une couche en Ga Al As.

8. Laser à semi-conducteur doté d'une structure à fenêtres, selon la revendication 4, dans lequel:

ladite section élargie de la gorge en forme de V possède une longueur de 150 µ; et

chacune desdites sections plus étroites de la gorge en forme de V possède une longueur de 50 µ.

FIG. 1
PRIOR ART

FIG. 2

FIG. 3

FIG. 4

FIG. 6

FIG. 5

FIG. 7

FIG. 8

FIG. 9

FIG. 10

FIG. 11

2

FIG. 12

FIG. 13

FIG. 14

FIG. 15

FIG. 16

FIG. 17

FIG. 18

FIG. 19

FIG. 21

FIG. 20

FIG. 22

FIG. 23